# EUROPEAN PATENT APPLICATION

(11) **EP 4 582 300 A1**
(43) Date of publication of application: **09.07.2025**
(21) Application number: 24150352.3
(22) Date of filing: 04.01.2024
(51) Int. Cl.: B60L 53/30, B60L 53/10, B60L 53/14, B60L 53/60, G01R 31/66

(54) **VEHICLE CHARGING STATION AND METHOD OF MONITORING A CONNECTOR OF A VEHICLE CHARGING STATION**

(71) Applicant: ABB E-mobility B.V., 2629 JG Delft (NL)
(72) Inventor: DREIER-SCHMIDT, Sebastian, 02827 Goerlitz (DE); GARCIA-FERRE, Francisco, 5405 Baden (CH); GAUTSCHI, Simon, 8006 Zurich (CH); UGUR, Ali, 2545 XP Den Haag (NL)
(74) Representative: Zimmermann & Partner Patentanwälte mbB

(57) **Abstract**

A vehicle charging station is described. The charging station includes a direct current, DC, power source configured for providing a charging power for charging an electric vehicle, a charging cable with a connector for electrically contacting a vehicle inlet of the electric vehicle, a connector holder with a station inlet configured for electrically contacting the connector when the connector is inserted into the connector holder, and a contact resistance sensor electrically connected to the station inlet. The resistance sensor is configured for measuring a resistance of at least one electrical contact formed between the connector and the station inlet. The charging station further includes a controller. The controller is configured for causing the vehicle charging station to perform a connector monitoring routine. The connector monitoring routine includes causing the DC power source to provide a measuring power while the connector is inserted into the connector holder so that a measuring current flows between the connector and the station inlet, and receiving a resistance value from the resistance sensor. The resistance value is indicative of a resistance of the at least one electrical contact.

## Description

Aspects of the invention relate to the charging of electric vehicles, in particular a vehicle charging station and a connector of the vehicle charging station. Further aspects relate to monitoring the connector while the connector is inserted into a connector holder of the vehicle charging station. Further aspects relate to sensing a resistance and deriving a connector status indicator from a resistance value.

### Technical background:

Electric vehicles typically include an on-board battery to power a drivetrain of the electric vehicle. One method of charging the on-board battery includes connecting the electric vehicle to a charging station by inserting a charging connector into a vehicle inlet, and providing a charging power by the charging station. The electric vehicle is typically immobilized during charging.

Recent improvements in charging technology aim to decrease vehicle downtime during charging by increasing the charging power. For example, the Megawatt Charging System known at the time of filing this disclosure aims to provide a direct current (DC) charging power of up to 3.75 megawatts (MW). Even higher charging powers are envisioned for some applications. Such charging systems may provide the charging power at currents of up to 3000 Amperes (A), and in some configurations utilize active cooling of the charging cable and/or connector. Beneficially, such charging systems may charge even large electric vehicles with limited downtime.

To provide a reliable and safe charging connection, the electrical contacts formed between the connector and the vehicle inlet should have a stable, low resistance. An increase in resistance may result in localized heating of the contact, which may cause a reduction of the available charging power, charging interruptions, degrade the contacts, or, in rare cases, even affect safety. A common cause for an increase of the contact resistance may be wear, deterioration or damage to the connector. Such degradation may be caused by repeated thermal cycling, mechanical stress during connecting and disconnecting the connector, or other types of damage due to mishandling of the connector. Accordingly, operating a vehicle charging station may require regularly inspecting and/or replacing faulty connectors. Regular maintenance may be time consuming and costly, while prolonged service intervals may potentially cause an undesirable interruption of the charging service.

Thus, there is a need for an improved vehicle charging system, and an improved method of monitoring a connector of a vehicle charging station. The present disclosure solves the above-described problem at least in part.

### Summary of the invention

The invention is set out in the appended set of claims.

According to an aspect, a vehicle charging station is described. The charging station includes a direct current, DC, power source configured for providing a charging power for charging an electric vehicle, a charging cable with a connector for electrically contacting a vehicle inlet of the electric vehicle, a connector holder with a station inlet configured for electrically contacting the connector when the connector is inserted into the connector holder, and a contact resistance sensor electrically connected to the station inlet. The resistance sensor is configured for measuring a resistance of at least one electrical contact formed between the connector and the station inlet. The charging station further includes a controller. The controller is configured for causing the vehicle charging station to perform a connector monitoring routine. The connector monitoring routine includes causing the DC power source to provide a measuring power while the connector is inserted into the connector holder so that a measuring current flows between the connector and the station inlet, and receiving a resistance value from the resistance sensor. The resistance value is indicative of a resistance of the at least one electrical contact.

According to an aspect, a method of monitoring a connector of a vehicle charging station is described. The vehicle charging station includes a direct current, DC, power source configured for providing a charging power for charging an electric vehicle, a charging cable with a connector for electrically contacting a vehicle inlet of the electric vehicle, and a connector holder comprising a station inlet configured for electrically contacting the connector when the connector is inserted into the connector holder. The method includes inserting the connector into the connector holder, selectively enabling the DC power source to provide a measuring power while the connector is inserted into the connector holder, and receiving a resistance value from the resistance sensor. The resistance value is indicative of the resistance of the at least one electrical contact.

According to an aspect, a vehicle is described. The vehicle may be an electric or hybrid vehicle. The vehicle may be a plug-in vehicle, such as a plug-in hybrid or battery-electric vehicle. The vehicle typically includes an on-board battery for holding an electric charge and powering a drivetrain, such as a propulsion system including one or more electric motors. The vehicle may be a passenger vehicle, such as a car, or a commercial vehicle, such as a truck or lorry. The vehicle may be a construction and/or industrial vehicle. The vehicle may be an aircraft, such as an airplane, helicopter, or variations thereof. The electric vehicle may be a watercraft, such as a boat or ship. The electric vehicle may be a rail-going vehicle, such as a train or locomotive.

According to an aspect, a vehicle charging station is described. The vehicle charging station typically is provided as or in a static installation, such as a charge point or an electric vehicle supply installation. The vehicle charging station may be configured for direct current (DC) charging, fast-charging, and/or even megawatt charging. For example, the vehicle charging station may be configured for providing a charging power of at least 50 kW, 100 kW, 200 kW, at least 350 kW, at least 500 kW, at least 750 kW, at least 1 MW, at least 2 MW, or even at least 3 MW. For example, the vehicle charging station may be configured as a megawatt charging system (MCS). For example, the vehicle charging station may be configured for providing the charging power at a current of at least 500 Ampere (A), at least 750 A, at least 1000 A, at least 1500 A, at least 2000 A, or even at about 3000 A. The charging power may have a voltage of at least 100 Volt (V), at least 200 V, at least 500 V, at least 750 V, or even at least 1000 V.

According to an aspect, the vehicle charging station may include a charging column. The vehicle charging station includes a charging cable and a connector provided at an end of the cable. The connector is configured for being inserted, and/or plugged into a vehicle inlet for forming a transient electrical connection between the charging station and the vehicle. Optionally, the charging station may include further components, such as a socket outlet configured for having inserted therein a plug of the charging cable provided at an end other than the connector end. Alternatively, the charging cable may be permanently attached to the charging station.

According to an aspect, the charging station may include a liquid cooling system. The liquid cooling system may be configured for cooling the charging cable, the connector, the station inlet and/or the vehicle inlet. For example, the charging cable may include liquid channels for circulating a cooling liquid, such as a cooling oil. Beneficially, the cooling system may enable the charging cable and/or the connector to transfer larger charging currents and/or charging powers than in a non-liquid-cooled charging station, particularly while providing a comparably light charging cable suitable for being manually operated, e.g. manually picked up, positioned about, and/or plugged into the vehicle inlet.

According to an aspect, the charging station includes a DC power source configured for providing a charging power, particularly a DC charging power, for charging the electric vehicle, e.g. a battery of the electric vehicle. The charging station may be configured for directly charging the battery of the electric vehicle, e.g. by directly interfacing with the battery, particularly without a vehicle converter being provided in-between the vehicle inlet and the battery. Beneficially, the electric vehicle may be devoid of, or not require, charging logic and/or converters, which may beneficially allow higher charging rates than with a charging station providing an AC charging power. The DC power source may be a converter, such as a converter configured for converting an AC grid power into a DC charging power.

According to embodiments, a connector is described. The connector may be a Megawatt Charging System connector, such as a described in "CharIN Whitepaper Megawatt Charging System (MCS), Recommendations and requirements for MCS related standards bodies and solution suppliers, Version 1.0, 2022-11-25", and/or according to standard IEC 61851 known at the time of filing this disclosure. According to embodiment, the connector may be connector as described in one or more of the standards ISO 5474-3, IEC TS 63379, IEC 61851-23-3, ISO 15118, and/or J3271-1 to -5 as known at the time of filing this disclosure.

Beneficially, the charging station is configured for obtaining a resistance value indicative of a resistance of an electrical contact formed between the connector and the station inlet. Based on the resistance value, a connector status indicator may be derived in a simple, efficient or even automated manner. Based on the connector status indicator, a connector status may be monitored with low effort, and monitoring and/or maintenance may be performed more efficiently. Beneficially, the systems and methods described herein may increase safety and uptime of the charging station, and/or reduce maintenance and operating costs.

Further advantages, features, aspects and details that can be combined with embodiments described herein are evident from the dependent claims, the description and the drawings.

### Brief description of the Figures:

The details will be described in the following with reference to the figures, wherein
- Fig. 1: shows a schematic view of a charging station according to embodiments;
- Fig. 2: shows a schematic circuit diagram showing a resistance measurement circuit in a charging station according to embodiments; and
- Fig. 3: shows a method of monitoring a connector of a vehicle charging station according to embodiments.

### Detailed description of the Figures and of embodiments:

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations.

Within the following description of the drawings, the same reference numbers refer to the same or to similar components. Generally, only the differences with respect to the individual embodiments are described. Unless specified otherwise, the description of a part or aspect in one embodiment applies to a corresponding part or aspect in another embodiment as well. Some aspects of the present disclosure may be described with reference to an apparatus, while being applicable to a method described herein. Likewise, aspects described with reference to a method may be applicable to an apparatus, such as a controller of the apparatus and/or a use of the apparatus.

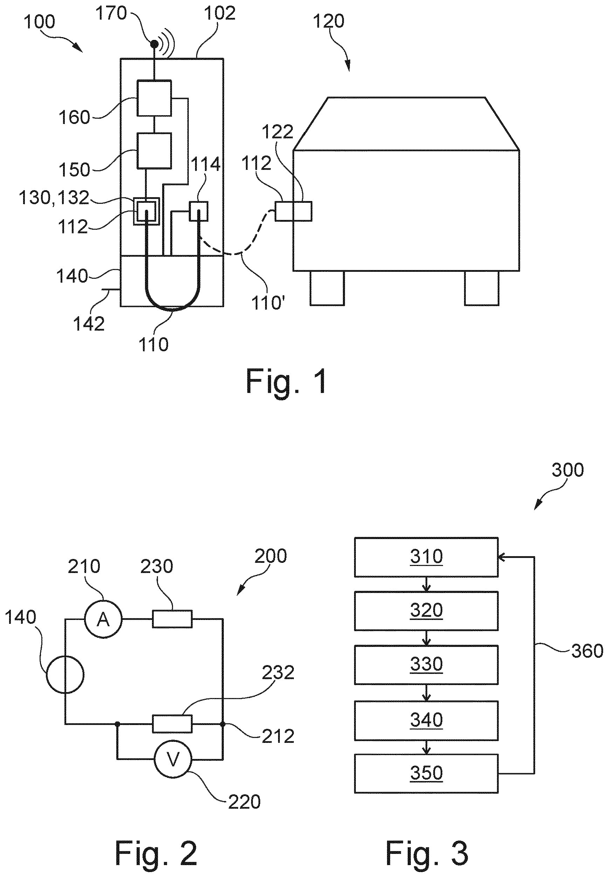

Referring now to Fig. 1, a charging station 100 is shown. A charging cable 110 is shown in Fig. 1 in a charging configuration 110' as indicated by the dotted line, and in a standby configuration of the charging cable 110 as indicated by the solid line. The charging cable 110 and has a connector 112 provided at a first end of the charging cable 110. The connector 112 may be inserted into a vehicle inlet 122 of an electric vehicle 120, particularly for charging the electric vehicle 120. Accordingly, the connector 112 is configured for forming an electrical connection with the vehicle inlet 122, particularly for charging the electric vehicle 120 and/or a battery of the electric vehicle. Fig. 1 shows the charging cable in a charging configuration 110', in which the connector is plugged into the electric vehicle.

The charging station 100 incudes a direct current (DC) power source 140. According to embodiments, the power source 140 may be a converter configured for converting an input power, such as a grid power received via an electrical connection 142 from a power grid, into a charging power. Likewise, other input power sources know at the time of filing of this disclosure may be utilized.

The charging power may be provided to the electric vehicle as a DC charging power. As shown in Fig. 1, the power source 140 may be electrically connected to a plug 114, the plug 114 forming a connection between the charging station column 102 and the charging cable 110. Likewise, the power source 140 may be directly connected to the charging cable.

According to embodiments, the charging power may be provided to the electric vehicle 120 via electric contacts formed between the connector 112 and the vehicle inlet 122. For example, the contacts may include a -DC contact, a +DC contact, and optionally a protective earth (PE) contact. Accordingly, the charging power may be a DC signal.

According to embodiments, the connector 112 may further include communication and/or detection pins or pin receptacles configured for forming communication and/or detection contacts between the charging station 100 and the vehicle inlet 122 of the electric vehicle 120. For example, the connector 112 may include four communication pins for forming an interface with the electric vehicle 120 according to an electric vehicle charging and/or communication standard, such as ISO 15118, particularly ISO 15118-20 as known at the time of filing this disclosure. The power source 140 may be configured for adjusting the charging power according to a communication between the electric vehicle 120 and the charging station, such as a controller 160 of the charging station, e.g. to set and/or limit a power of the charging power, or to start/stop the charging power according to signals received via the interface.

When not connected to an electric vehicle 120, the connector 112 is inserted into a connector holder 130, as shown in Fig. 1 for the charging cable 110. The connector 112 being inserted into the connector holder 130 may be a standby configuration of the charging station 100, such as a typical configuration of the charging station 100 in-between charging cycles. The connector holder 130 may be provided, e.g. integrally provided, and/or integrated in the charging station 100, such as a body of the charging station 100, such as the column 102 of the charging station.

The connector holder 130 includes a station inlet 132. The station inlet 132 may be similar and/or identical to a vehicle inlet 122. In particular, the station inlet 132 may include some or all of the contacts of the vehicle inlet 122. Accordingly, the station inlet 132 is configured for electrically contacting the connector 112 when the connector 112 is inserted into the connector holder 130.

The charging station 100 includes a resistance sensor 150. Features of a resistance sensor 150 according to embodiments are described in further detail with reference to Fig. 2. The resistance sensor 150 is electrically connected to the station inlet 132. The resistance sensor 150 is configured for measuring a resistance of one or more contacts formed between the connector 112 and the station inlet, particularly when the connector 112 is inserted into the connector holder 130. For example, when inserting the connector 112 into the connector holder 130, electrical contacts may be formed between a +DC pin and pin receptacle, a -DC pin and pin receptacle, and/or a PE pin and pin receptacle of the connector 112 and the station inlet 132. Generally, the contact resistance of the electrical contacts formed between the connector 112 and the vehicle inlet 122 should be low when charging an electric vehicle to provide a safe and reliable electrical connection, and to minimize resistive losses. A deteriorated and/or damaged connector 112 may have one or more pins and/or pin receptacles having and/or causing an increased contact resistance. Beneficially, by measuring the resistance when the connector 112 is inserted into the connector holder 130, a deterioration of the connector may be monitored, identified and/or quantified based on the resistance measured by the resistance sensor 150.

According to embodiments, the charging station 100 includes a controller 160. As shown in Fig. 1, the controller 160 may be communicatively connected to the DC power source 140 and/or the resistance sensor 150, particularly for providing control instructions to the power source 140, and/or for receiving measured values from the resistance sensor 150. Additionally, the controller may be configured for controlling additional operations of the charging station, such as operations associated with charging the electric vehicle 120. The controller 160 may include a processor and a memory comprising instructions that, when carried out by the processor, cause the controller 160 to operate according to aspects and/or embodiments described herein. In particular, the instructions may cause the controller 160 to operate the charging station 100 according to a method described herein, such as the method 300 described with reference to Fig. 3.

The controller 160 is configured for causing the vehicle charging station to perform a connector monitoring routine. The connector monitoring routine may be performed when the connector 112 is inserted into the connector holder 130. Accordingly, the controller 160 may be configured for detecting if the connector 112 is inserted into the connector holder 130.

The connector monitoring routine includes providing, by the DC power source 140, a measuring power so that a measuring current flows between the connector 112 and the station inlet 132. Accordingly, the controller 160 may be configured for causing the DC power source 140 to provide the measuring power.

The connector monitoring routine further includes receiving a resistance value from the resistance sensor 150, particularly receiving the resistance value by the controller 160. The resistance value is indicative of the resistance of at least one electrical contact, particularly one or more electrical contacts formed between the connector 112 and the station inlet 132. For example, the resistance value may include one or more resistances, expressed e.g. as an ohmic resistance or conductance, or any other unit of measurement, for one or more of the -DC, +DC and/or PE contacts, and/or even the communication or detection contacts.

Referring now to Fig. 2, a schematic circuit diagram showing a resistance measurement circuit 200 in a charging station according to embodiments, such as the charging station 100, is shown. The resistance measurement circuit 200 may be an implementation of a four terminal sensing application. The measurement circuit 200 may be formed between the power source 140, the charging cable 110, the connector 112, the station inlet 132, and/or the resistance sensor 150. Fig. 2 may be considered an equivalent circuit diagram. The circuit shown in Fig. 2 may be suitable for measuring the resistance of a single contact. Likewise, the circuit shown in Fig. 2 may be suitable for measuring the resistance of a plurality of contacts, such as two or more contacts. For example, the circuit may be formed when transmitting the charging power through one of the +DC, -DC and/or PE contacts. Likewise, the circuit may be formed when transmitting the charging power through two or more of the +DC, -DC and/or PE contacts, in which case a resistance may indicate the combined resistance of the two or more contacts. Accordingly, a charging station 100 may include one, two, or several of the measurement circuits 200.

Resistance 230 indicates a resistance of the charging cable 110, and may further indicate intrinsic resistances of other components of the charging station, such as an internal resistance of the power source 140 and/or internal electrical connection. Resistance 232 indicates the resistance of the electrical connection between the connector 112 and the station inlet 132. When the connector 112 is inserted into the station inlet 132, a closed circuit is formed.

In a connector monitoring routine, the power source 140 provides a measuring power. The measuring power may be provided for a limited duration, such as for about 1 second (s), about 2s, about 5s, or about 10s. A current of the measuring power may be measured by the current sensor 210. The current sensor 210 may be integrated into the power source 140, may be included in the resistance sensor 150, or may be a separate component of the charging station 100. In some embodiments, the current sensor 210 may be optional, e.g. in cases in which the power source 140 is configured as a constant current source providing a known current.

According to embodiments, the power source 140 may be configured as a constant current source, a constant voltage source, and/or a constant power source while providing the measuring power.

Resistance 232 indicates a resistance of an electrical contact formed between the connector 112 and the station inlet 132. For example, in the equivalent circuit diagram, the node 212 may indicate the connector side of the electrical contact, the electrical contact being represented by resistance 232. A voltage sensor 220 is provided so that one of the nodes of the voltage sensor is connected to the connector side of the contact, and another node of the voltage sensor is connected to the station inlet side of the contact. While Fig. 2 shows the node 212 being provided between the resistances 230, 232, the connector side node may be provided at other points within the measurement circuit 200. For example, in some embodiments, the voltage sensor 220 may be provided essentially in parallel to the power source. In some embodiments, an electrical connection between the voltage sensor 220 and the connector side of the contact may be formed via one or more of the communication and/or detection contacts. The resistance 230 may represent the resistance of the charging cable, while the resistance 232 may represent the resistance of the electrical contact. A voltage drop measurement may be performed for either resistance 232, or resistance 230 in combination with resistance 232.

As shown in Fig. 2, the voltage sensor 220 is configured for sensing a voltage drop caused by the resistance of the electrical contact. Accordingly, based on e.g. the current sensed by current sensor 210, the voltage drop sensed by voltage sensor 220, and/or optionally the known or estimated resistance 230, a resistance valve of the connector may be derived by applying Ohm's law.

While in Fig. 2 the voltage sensor 220 and the current sensor 210 are shown as separate entities, the voltage sensor 220 and/or the current sensor 210 may be included in the resistance sensor 150. Likewise, the resistance sensor may be electrically and/or communicatively connected to one or more independently provided current sensors 210 and/or voltage sensors 220 of the charging station 100, and utilize the provided sensor values to determine a resistance value. In some embodiments, the voltage sensor 220 may be provided within the charging station 100. In some embodiments, the voltage sensor 220 may be provided within, e.g. integrated into, the connector 112.

According to embodiments, the measuring power has a measuring current and a measuring voltage. The measuring current is beneficially chosen such that an expected resistance of the electrical connection causes a measurable voltage drop across the resistance 232. For example, the measuring current may be at least 50 A, at least 75 A, at least 100 A, at least 200 A, or even at least 500 A. It should be appreciated that, since the resistance measurement circuit 200 generally has only a small overall resistance, the measuring power may have a lower voltage than the charging power, such as less than 200 V, less than 100 V, less than 50 V, or even less than 20 V. Advantageously, the power consumption for performing a connector monitoring routine may be low.

According to embodiments, the controller 160 is configured for deriving, from the resistance value, a connector status indicator. The connector status indicator may be indicative of a connector condition of the connector 112. For example, for a connector 112 having expected and/or nominal resistance values, a connector status indicator may be derived that indicates a nominal connector condition. For example, for a connector 112 having higher than expected and/or nominal resistance values for one or more electrical contacts, a connector status indicator may be derived that indicates a faulty and/or deteriorated connector condition.

According to embodiments, the charging station 100, particularly the controller 160, may be configured for deriving device status information from the resistance value. The device status information may include the connector status indicator.

According to embodiments, the resistance value and/or the connector status indicator may be utilized, by the charging station 100 or additional systems, to control an operation of the charging station. For example, and not limited thereto, in case the controller 160 determines that a resistance value is outside a predetermined nominal and/or expected range, the controller 160 may prevent further charging operations to be performed by the charging station 100 until the connector 112 is repaired or replaced.

The charging station 100, particularly the controller 160, may include a network interface for connecting the charging station 100 to a data network, in particular a global data network. The data network may be a TCP/IP network such as Internet. The controller 160 may be operatively connected to the network interface for carrying out commands received from the data network. The commands may include a control command for controlling the charging station 100 to carry out a task such as performing the connector monitoring routine and/or sending the device status information to a receiver via the data network. In this case, the controller 160 is adapted for carrying out the task in response to the control command. The commands may include a status request. In response to the status request, or without prior status request, the controller 160 may be adapted for sending a status information to the network interface, and the network interface is then adapted for sending the status information over the network. The commands may include an update command including update data. In this case, the controller 160 is adapted for initiating an update in response to the update command and using the update data.

The data network may be an Ethernet network using TCP/IP such as LAN, WAN or Internet. The data network may comprise distributed storage units such as Cloud. Depending on the application, the Cloud can be in form of public, private, hybrid or community Cloud.

In the example shown in Fig. 1, the network interface is a wireless interface 170 for connecting the charging station 100 to a wireless network, such as a local WLAN or a mobile data network, such as an LTE or 5G network. Likewise, the network interface may be connected to a wire-based network, such as a (local) Ethernet network or a wide area network.

According to embodiments, a remote system is described. The charging station 100 may be communicatively connected, via the network interface, to the remote system configured for receiving data from the charging station 100, such as data including the device status information and/or the connector status indicator. The remote system may be configured for generating a warning signal based on the connector status indicator, particularly in case the connector status indicator indicates a connector deterioration. The warning signal may be e.g. an automated message, such as an email message, an entry into a service schedule, an audio and/or visual indicator, or the like. Beneficially, several charging stations may be connected to the remote system, which may allow an operator of the several charging stations to easily and remotely monitor the charging stations, and perform targeted repairs and/or maintenance.

According to embodiments, the controller 160 is configured for automatically perform the connector monitoring routine. In some embodiments, the connector monitoring routine may be automatically performed each time the connector 112 is in inserted into the connector holder 130.

In some preferable embodiments, the monitoring routine may be performed in predefined intervals. For example, the monitoring routine may be performed after exceeding a predefined monitoring time interval. For example, the controller may be configured for performing a monitoring routine in case a predefined timespan following the last performing of the monitoring routine is exceeded, such as a timespan of 6 hours, 12 hours, 1 day, 2 days, or 5 days.

For example, a monitoring routine may be performed after exceeding a predefined number of vehicle charging operations. For example, the controller may be configured for performing a monitoring routine in case a predefined number of charging operations following the last performing of the monitoring routine is exceeded, such as 10 charging operations, 20 charging operations, 50 charging operations, 100 charging operations, or 200 charging operations.

For example, a monitoring routine may be performed after exceeding a predefined number of connection events. A connection event may be defined as the removal of the connector 112 from the connector holder 130, plugging the connector 112 into a vehicle inlet 122, and/or the reinsertion of the connector 112 into the connector holder. A connection event does not require the performing of a charging operation. For example, the controller may be configured for performing a monitoring routine in case a predefined number of connection events following the last performing of the monitoring routine is exceeded, such as 10 connection events, 20 connection events, 50 connection events, 100 connection events, 200 connection events, 500 connection events, or 1000 connection events.

For example, a monitoring routine may be performed in response to receiving an instruction, particularly via the network interface, e.g. from a remote system, to perform the connector monitoring.

According to embodiments, the charging station 100 includes one or more temperature sensors. In particular, the connector 112 may include a connector temperature sensor, e.g. to measure a temperature of the connector 112 during charging, e.g. for overtemperature protection during charging. Additionally, the connector holder 130 and/or station inlet may include an inlet temperature sensor. The temperature sensor(s) may be communicatively connected to the controller 160. The controller 160 may be configured for receiving a temperature value from the temperature sensor(s) and evaluate the temperature value when performing a connector monitoring routine. For example, the controller 160 may be configured for ascertaining, before a monitoring routine is performed, that the temperature sensed by the connector temperature sensor is within a predefined, allowable temperature range, such as between -40°C to 90°C, between 0°C and 70°C, or more specifically 50°C or lower. This may beneficially prevent a measurement under non-suitable ambient temperatures, and/or in case the connector would be at a risk of overheating. Furthermore, the controller 160 may be configured to ascertain, before a monitoring routine is performed, that the temperatures sensed by the connector temperature sensor and the inlet temperature sensor do not differ by e.g. ± 10°C or more, more specifically ± 5°C or more. According to embodiments, the controller 160 may be configured for correlating and/or correcting a resistance value according to the temperature value. Beneficially, the one or more temperature sensors may allow the controller to more reliably and/or accurately determine a resistance value. For example, the temperature value(s) may be used to determine a more accurate value of the (expected) resistance 230 and/or 232, which may be temperature dependent.

Referring now to Fig. 3, a method 300 of monitoring a connector of a vehicle charging station is described. The charging station may be the charging station 100 described with reference to Fig. 1 and Fig. 2. The method may be performed, at least in part, by the charging station 100, particularly the resistance sensor 150 and/or the controller 160 of the charging station 100. According to embodiments, the method 300 may describe a use of the charging station 100.

The charging station used in the method 300 includes a direct current, DC, power source configured for providing a charging power for charging an electric vehicle, a charging cable comprising a connector for electrically contacting a vehicle inlet of the electric vehicle, and a connector holder comprising a station inlet configured for electrically contacting the connector when the connector is inserted into the connector holder.

The method 300 includes inserting 310 the connector into the connector holder. The inserting 310 may be performed by a user of the charging station, e.g. after a charging of an electric vehicle is completed. The inserting 310 may include directing the user of the vehicle charging station to insert the connector, e.g. to complete the charging cycle. Inserting the connector may include connecting the connector with a station inlet. The inserting 310 may establish at least one electrical connection between the connector and a station inlet of the charging station, e.g. by causing at least one pin to be inserted into a corresponding receptacle and/or socket.

The method 300 may optionally include operation 320. Operation 320 may be a temperature check. In operation 320, a connector temperature is sensed, e.g. by a temperature sensor, such as a connector temperature sensor and/or a station inlet temperature sensor. Operation 320 may include determining if the connector temperature is outside a predefined temperature range. The predefined temperature range may, for example, be defined as a temperature between -40 C to 90°C, between 0°C and 70°C, or more specifically 50 °C or lower. Operation 320 may further include determining if a connector temperature differs from an inlet temperature by ± 10°C or more, and/or ± 5°C or more. In case it is determined that the connector temperature is outside the predefined temperature range, operation 320 may include delaying further execution of the method 300, particularly delaying the enabling of the power source, until the temperature is within the predefined temperature range.

The method 300 includes selectively enabling 330 the DC power source to provide a measuring power while the connector is inserted into the connector holder. Providing the measurement power may cause a current to flow through at least one electrical contact formed between the connector and the station inlet. A resistance of the at least one electrical contact may affect the current and/or the measuring power. For example, and not limited thereto, a higher resistance may reduce a current of a measuring power having a constant voltage compared to a lower resistance.

The method 300 includes receiving 340 a resistance value from the resistance sensor, the resistance value being indicative of the resistance of the at least one electrical contact. Accordingly, the method 300 may include measuring a resistance of the at least one electrical contact. Measuring the resistance may include providing the measurement power at a known or measured current, and monitoring a voltage drop over the electrical contact, the voltage drop being indicative of the resistance of the electrical contact. Additionally, or alternatively, a resistance of the electrical contact may be determined by determining a resistance of a circuit including the electrical contact, such as the circuit shown in Fig. 2, and subtracting a known or estimated resistance, such as the resistance 230, from the resistance of the circuit. Determining the resistance of the circuit may include determining a current resulting from a voltage of the measuring power, and applying Ohm's law.

The method 300 may optionally include deriving 350, from the resistance value, a connector status indicator. The connector status indicator is indicative of a connector condition. For example, the connector status indicator may indicate, based on a nominal and/or expected resistance value, that the connector condition is acceptable. For example, the connector status indicator may indicate, based on a higher than expected and/or nominal resistance value, that the connector condition is faulty. Beneficially, further increments may be utilized for the connector status indicator. For example, a resistance value may be higher than expected, but still within an allowable and/or nominal range, and a connector status indicator derived from the resistance value may indicate a connector deterioration which may prompt an operator to schedule future connector maintenance and/or replacement.

The method 300 may include, after receiving 340 the resistance value and/or after deriving 350 the connector status indicator, transmitting a data packet including the connector status indicator and/or the resistance value to a remote system. For example, the connector status indicator may be transmitted to the remote system. The connector status indicator may be transmitted in regular intervals, such as daily, and/or after each connector monitoring routine. Alternatively, the connector status indicator may be transmitted under the condition that the connector status indicator indicates a non-nominal connector status. The remote system may be a computer, such as a server or a cloud-based system, and/or be configured as a (centralized) monitoring system for a plurality of charging stations. In case the connector status indicator indicates a connector deterioration, which may include a connector fault, a warning signal indicating the connector deterioration may be generated, e.g. by the remote system and/or the charging station. The warning signal may be communicated to maintenance personnel, e.g. in the form of an electronic message, an audio-visual signal, an alarm, and/or an entry in a maintenance schedule. Based on the warning signal, maintenance may be performed and/or scheduled. Beneficially, a status of a plurality of charging stations may be monitored without requiring maintenance personnel to perform on-site tests, thereby improving monitoring efficiency.

According to embodiments, the method 300 may be a connector monitoring routine. In some embodiments, the method 300 may include repeatedly performing 360 the connector monitoring routine. In particular, the method 300 may include performing a series of connector monitoring routines over a predefined timeframe. For example, the predefined timeframe may be several days, such as 5 days, 10 days, 20 days, 30 days, or more than 30 days. The connector monitoring routine may be performed e.g. after exceeding a predefined monitoring time interval, exceeding a predefined number of vehicle charging operations, exceeding a predefined number of connection events, and/or receiving an instruction to perform a connector monitoring according to the connector monitoring routine.

According to embodiments, a plurality of connector monitoring routines may be performed within the predefined timeframe. Resistance values may be stored, e.g. in a memory of a controller, such as the controller 160 of the charging station 100, or even remotely.

According to embodiments, deriving 350 the connector status indicator may include repeatedly performing 360 the series of connector monitoring routines over the predefined timeframe, and deriving the connector status indicator from a series of resistance values received in the series of connector monitoring routines. For example, deriving 350 the connector status indicator may include evaluating some or all resistance values recorded within the predefined timeframe. The resistance values may be a time series. The evaluating may include applying statistical methods, such as trend analysis, extrapolation, or other pattern detection methods. Beneficially, deriving the connector status indicator from a series of resistance values may allow a more accurate detection of a potential future connector fault. For example, a resistance value derived from a single connector monitoring routine may indicate that the connector status is nominal, while evaluating a series of resistance values may show that the connector is deteriorating at a determinable or determined rate, and/or will likely enter a fault state within a determinable timespan. Additionally, or alternatively, the time series may be utilized to more easily detect sudden changes in a contact resistance, e.g. by averaging earlier values of the time series to determine a baseline or base value for each contact, which may beneficially be used to account for small variances between contacts due to e.g. manufacturing variances, thereby decreasing the likeliness of false-positive result.

## Claims

1. A vehicle charging station, comprising:
a direct current, DC, power source configured for providing a charging power for charging an electric vehicle;
a charging cable comprising a connector for electrically contacting a vehicle inlet of the electric vehicle;
a connector holder comprising a station inlet configured for electrically contacting the connector when the connector is inserted into the connector holder;
a contact resistance sensor electrically connected to the station inlet, the resistance sensor being configured for measuring a resistance of at least one electrical contact formed between the connector and the station inlet; and
a controller, wherein the controller is configured for causing the vehicle charging station to perform a connector monitoring routine comprising:
causing the DC power source to provide a measuring power while the connector is inserted into the connector holder so that a measuring current flows between the connector and the station inlet; and
receiving a resistance value from the resistance sensor, the resistance value being indicative of a resistance of the at least one electrical contact.

2. The vehicle charging station according to claim 1, wherein the DC power source is configured for providing a charging power of at least 350 kW.

3. The vehicle charging station according to claim 1 or 2, further comprising a liquid cooling system for liquid-cooling at least one selected from the group consisting of the charging cable, the connector and the station inlet.

4. The vehicle charging station according to any one of the preceding claims, wherein the measuring current is at least 100 A.

5. The vehicle charging station according to any one of the preceding claims, wherein the controller is further configured for:
deriving, from the resistance value, a connector status indicator, the connector status indicator being indicative of a connector condition.

6. The vehicle charging station according to any one of the preceding claims, the charging station being configured for deriving device status information from the resistance value,
the charging station further comprising a network interface for connecting the controller to a data network, wherein the controller is operatively connected to the network interface for sending the device status information to the data network.

7. The vehicle charging station according to any one of the preceding claims, wherein the controller is configured for automatically performing the connector monitoring routine in response to at least one selected from the group consisting of:
- exceeding a predefined monitoring time interval;
- exceeding a predefined number of vehicle charging operations;
- exceeding a predefined number of connection events;
- receiving an instruction to perform the connector monitoring.

8. The vehicle charging station according to any one of the preceding claims, further comprising a temperature sensor for sensing a temperature of the connector.

9. Method of monitoring a connector of a vehicle charging station, the vehicle charging station comprising:
a direct current, DC, power source configured for providing a charging power for charging an electric vehicle;
a charging cable comprising a connector for electrically contacting a vehicle inlet of the electric vehicle;
a connector holder comprising a station inlet configured for electrically contacting the connector when the connector is inserted into the connector holder; the method comprising:
inserting the connector into the connector holder;
selectively enabling the DC power source to provide a measuring power while the connector is inserted into the connector holder; and
receiving a resistance value from the resistance sensor, the resistance value being indicative of the resistance of the at least one electrical contact.

10. The method according to claim 9, further comprising:
deriving, from the resistance value, a connector status indicator, the connector status indicator being indicative of a connector condition.

11. The method according to claim 10, further comprising:
transmitting the connector status indicator to a remote system and, under the proviso that the connector status indicator indicates a connector deterioration, generating a warning signal indicating the connector deterioration.

12. The method according to any one of claims 9 to 11, further comprising:
before providing a measuring power, sensing a connector temperature and, under the proviso that the connector temperature is outside a predefined temperature range, delaying providing the measurement power until the temperature is within the predefined temperature range.

13. The method according to claim 12, wherein the predefined temperature range defines a temperature at or below 50 °C.

14. The method according to any one of claims 10 to 13, wherein deriving the connector status indicator comprises performing a series of connector monitoring routines over a predefined timeframe, and deriving the connector status indicator from a series of resistance values received in the series of connector monitoring routines.

15. The method according to any one of claims 9 to 13, wherein the method is automatically performed by the vehicle charging station after a predefined number of vehicle charging operations and/or a predefined number of connection events.
